# EUROPÄISCHE PATENTSCHRIFT

(11) **EP 1 606 981 B1**
(45) Veröffentlichungstag und Bekanntmachung des Hinweises auf die Patenterteilung: **05.01.2011**
(21) Anmeldenummer: 04719948.4
(22) Anmeldetag: 12.03.2004
(51) Int. Cl.: H05K 3/12, H05K 3/00

(54) **VERFAHREN UND VORRICHTUNG ZUM AUSRICHTEN VON SUBSTRAT UND DRUCKSCHABLONE BEIM LOTPASTENDRUCK**
METHOD AND DEVICE FOR ALIGNING A SUBSTRATE AND A PRINTING SCREEN DURING SOLDER PASTE PRINTING
PROCEDE ET DISPOSITIF D'ALIGNEMENT D'UN SUBSTRAT ET D'UN GABARIT D'IMPRESSION LORS D'UNE IMPRESSION DE PATE DE BRASAGE

(30) Priorität: 13.03.2003 DE 10311821
(43) Veröffentlichungstag der Anmeldung: 21.12.2005
(73) Patentinhaber: Ekra Eduard Kraft GmbH, 74357 Bönnigheim (DE)
(72) Erfinder: HEYNEN, Roland, 52499 Baeswiler (DE)
(74) Vertreter: Grosse, Rainer
(86) Internationale Anmeldenummer: PCT/EP2004/002592
(87) Internationale Veröffentlichungsnummer: WO 2004/082345

(56) Entgegenhaltungen:
- EP-A- 0 906 827
- DE-A1- 3 928 527
- PATENT ABSTRACTS OF JAPAN Bd. 1999, Nr. 13, 30. November 1999 (1999-11-30) -& JP 11 218406 A (TANI DENKI KOGYO KK), 10. August 1999 (1999-08-10)

## Beschreibung

Die Erfindung betrifft ein Verfahren zum Ausrichten von Substrat und Druckschablone zueinander beim Bedrucken des Substrats mit Lotpaste sowie eine Vorrichtung zum Ausrichten von Substrat und Druckschablone zueinander beim Bedrucken des Substrats mit Lotpaste.

Beim Bedrucken von Substraten, insbesondere Leiterplatten mit Lotpaste, ist es bekannt, eine Leiterplatte in das Drucknest der Druckeinrichtung einzufahren. Das Einfahren erfolgt mit Abstand zur Druckschablone der Druckeinrichtung. Anschließend fährt eine optische Erfassungseinrichtung in den Bereich zwischen Substrat und Druckschablone um anhand von Strukturen von Substrat und Druckschablone eine Ausrichtung dieser beiden Teile zueinander zu ermöglichen. Die als Kamera ausgebildete optische Erfassungseinrichtung hat vorzugsweise zwei Objektive und kann daher gleichzeitig die Druckseite des Substrats und die der Druckseite des Substrats zugewandte Seite der Druckschablone inspizieren. Bei den Strukturen kann es sich beispielsweise um Leiterbahnstrukturen und/oder Substratkanten des Substrats beziehungsweise Drucköffnungen oder Kanten der Druckschablone handeln. Dort wo beim Druckprozess Lotpaste auf eine Leiterbahn, insbesondere ein Pad, aufgetragen werden soll, ist eine entsprechende, abtastbare Leiterbahnstruktur vorhanden auf dem Substrat und eine entsprechende Öffnung in der Druckschablone. Für einen einwandfreien Druck ist es erforderlich, das Substrat und Druckschablone vor dem Druckvorgang präzise zueinander ausgerichtet sind, um zu gewährleisten, dass die Lotpaste positionsgenau auf der Leiterbahn angeordnet wird. Bei hochintegrierten elektronischen Schaltungen sind die Abstände der einzelnen Leiterbahnen sehr klein, so dass eine hohe Präzision beim Drucken erforderlich ist. Der erwähnte Ausrichtvorgang mittels der optischen Erfassungseinrichtung ist bei dem Bedrucken jedes einzelnen Substrats eines Druckloses zu wiederholten, das heißt, stets fährt die optische Erfassungseinrichtung zwischen Substrat und Druckschablone ein, dann erfolgt eine Ausrichtung zwischen Substrat und Druckschablone und erst dann kann der Druckvorgang erfolgen. Für die Durchführung des Druckvorganges ist es erforderlich, die Kamera wieder aus dem Raum zwischen Substrat und Druckschablone herauszufahren. Erst dann können Druckschablonen und Substrat sich einander nähern und der Druckvorgang durchgeführt werden. Es wird deutlich, dass aufgrund dieser Vorgehensweise die für den Druckvorgang benötigte Zeit aufgrund des jeweiligen Ein- und Ausfahrens der Kamera relativ groß ist, das heißt, die pro Zeiteinheit zu bedruckende Anzahl der Substrate eines Druckloses ist relativ klein.

DE 3928527 offenbart eine Siebdruckmaschine mit einer elektronischen Kameras auf wersenden Steuereinrichtung.

Der Erfindung liegt daher die Aufgabe zugrunde, ein Verfahren und eine Vorrichtung anzugeben, bei der die sich für jedes Substrat aufzubringende Zykluszeit für das Aufbringen von Lotpaste verringert, so dass pro Zeiteinheit eine große Anzahl von Substraten eines Druckloses bedruckt werden können. Dabei soll eine hohe Präzision gewährleistet sein, das heißt, die Lotpastendepots werden hochgenau den jeweiligen Leiterbahnstrukturen oder dergleichen zugeordnet.

Diese Aufgabe wird durch folgendes Vorgehen gelöst. Es erfolgt ein Verbringen des ersten Substrates in eine beabstandete Gegenüberlage zur Druckschablone. Bei dem "ersten" Substrat handelt es sich um das erste Substrat eines Druckloses, das beispielsweise einige hundert Substrate umfasst. Anschließend fährt eine erste optische Erfassungseinrichtung, insbesondere eine Kamera, zwischen die Druckseite des ersten Substrats und die Druckschablone. Mit Hilfe dieser ersten optischen Erfassungseinrichtung erfolgt das Erfassen von positionsbestimmenden ersten Strukturen vom ersten Substrat und von der Druckschablone. Es werden also zueinander in Deckung zu bringende Strukturen auf dem ersten Substrat und der Druckschablone erfasst, wobei dies mindestens an zwei beabstandet zueinander liegenden Stellen erfolgen muss, um Verdreh-Ausrichtfehler zu vermeiden. Anschließend erfolgt ein Ausrichten von erstem Substrat und Druckschablone zueinander anhand von bei der Strukturenerfassung gewonnenen Informationen. Hierzu ist die Substrataufnahme und/oder die Druckschablonenhalterung sowohl in X-als auch Y-Richtung verfahrbar und auch in dieser Ebene verdrehbar. Ist das Ausrichten erfolgt, so wird anschließend mittels einer zweiten optischen Erfassungseinrichtung, die unterhalb des Drucknestes, also der Substrataufnahme, angeordnet ist, eine Erfassung von Referenzdaten von positionsbestimmenden zweiten Strukturen auf der der Druckseite abgewandten Seite des ersten, ausgerichteten Substrats vorgenommen. Mithin werden zweite Strukturen des ersten Substrates auf der nicht zu bedruckenden Seite des Substrats mittels der zweiten optischen Erfassungseinrichtung (zweite Kamera) ermittelt. Da zuvor eine Ausrichtung zwischen erstem Substrat und Druckschablone erfolgte, befindet sich das Substrat in der korrekten Druckposition, so dass mittels der zweiten optischen Erfassungseinrichtung die erfassten zweiten Strukturen im Hinblick auf ihre Lage, Größe und/oder Form ermittelt und das ermittelte Ergebnis in Form von Referenzdaten gespeichert werden kann. Da jedes Substrat eines Druckloses, also beispielsweise die gleichartigen Leiterplatten eines Druckloses, auf Ober- und Unterseite zueinander hochpräzise liegende Strukturen aufweisen, wird sich die ausgerichtete Position des Substrates im Drucknest aufgrund der der Druckseite abgewandten, erfassten Strukturen "gemerkt". Sind die Referenzdaten erfasst, so erfolgt ein Herausfahren der ersten optischen Erfassungseinrichtung und das erste Substrat kann auf der Druckseite bedruckt werden. Das bedruckte erste Substrat wird dann entfernt und das zweite Substrat des Druckloses in das Drucknest eingefahren, so dass es in Gegenüberlage zur Druckschablone liegt. Nunmehr ist es nicht mehr erforderlich, zwischen Substrat und Druckschablone die erste optische Erfassungseinrichtung einzufahren, um den Ausrichtvorgang zwischen Druckschablone und Substrat vorzunehmen, sondern es ist ausreichend, wenn mittels der zweiten optischen Erfassungseinrichtung die der Druckseite abgewandte Seite des zweiten Substrates hinsichtlich der dort vorhandenen Strukturen erfasst und auf diese Art und Weise Ist-Daten bestimmt werden. Wenn keine präzise Ausrichtung zwischen Substrat und Druckschablone vorliegt, werden die erfassten Ist-Daten von den zuvor beim ersten Substrat ermittelten Referenzdaten abweichen. Es ist daher aufgrund der sich aus dem Vergleich zwischen Ist-Daten und Referenzdaten ergebenden Informationen, ein Ausrichten des zweiten Substrats und Druckschablone zueinander vorzunehmen. Ist dies erfolgt, wird der Druckvorgang durchgeführt. Da -wie erwähnt- die erste optische Erfassungseinrichtung nicht bei jedem Substrat zwischen Substrat und Druckschablone fahren muss, sondern lediglich mittels der zweiten optischen Erfassungseinrichtung ab dem zweiten Substrat nur die der Druckseite abgewandte Seite des Substrats zur Erfassung der Ist-Daten inspiziert werden muss, kann der Druckzyklus wesentlich schneller erfolgen, so dass pro Zeiteinheit eine große Anzahl von Substraten eines Druckloses hochpräzise mit Lotpaste bedruckt werden kann.

Alternativ zu dem vorstehenden Verfahren ist es auch möglich, nach dem Erfassen der positionsbestimmenden ersten Strukturen vom ersten Substrat und von der Druckschablone mittels der ersten optischen Erfassungseinrichtung keine Ausrichtung von erstem Substrat und Druckschablone zueinander vorzunehmen. Es ist ausreichend, wenn Lageabweichungen zwischen diesen beiden Bauteilen mittels der ersten optischen Erfassungseinrichtung erfasst und "virtuell" in Form von Korrekturdaten ermittelt werden. Beim zweiten Substrat wird dann -ebenso wie vorstehend bereit beschrieben- vorgegangen, wobei das Ausrichten von zweitem Substrat und Druckschablone zueinander anhand eines Vergleichs von Referenzdaten und Ist-Daten und unter Berücksichtigung der Korrekturdaten vorgenommen wird, das heißt, die Korrekturdaten nehmen quasi ein "virtuelles" Ausrichten des ersten Substrats zur Druckschablone vor, wobei dies bei der Erfassung der zweiten Strukturen auf der der Druckseite abgewandten Seite des ersten Substrates, also bei der Erfassung der Referenzdaten, Berücksichtigung finden muss.

Die Erfindung betrifft ferner eine Vorrichtung zum Ausrichten von Substrat und Druckschablone zueinander beim Bedrucken des Substrats mit Lotpaste, wobei diese Vorrichtung insbesondere zur Durchführung der vorstehend erwähnten Verfahren verwendet werden kann. Die Vorrichtung weist eine zwischen Druckseite des Substrats und Druckschablone ein- und ausfahrbare, erste optische Erfassungseinrichtung auf und besitzt eine die der Druckseite gegenüberliegende Seite des Substrats inspizierende, zweite optische Erfassungseinrichtung. Ferner ist eine Korrekturvorrichtung vorgesehen, die die Erfassungsdaten der ersten optischen Einrichtung und die Inspektionsdaten der zweiten optischen Einrichtung verarbeitet und der Positionskorrektur von Substrat und Druckschablone relativ zueinander dient.

Vorteilhafte Weiterbildungen der Erfindung ergeben sich aus den Ansprüchen.

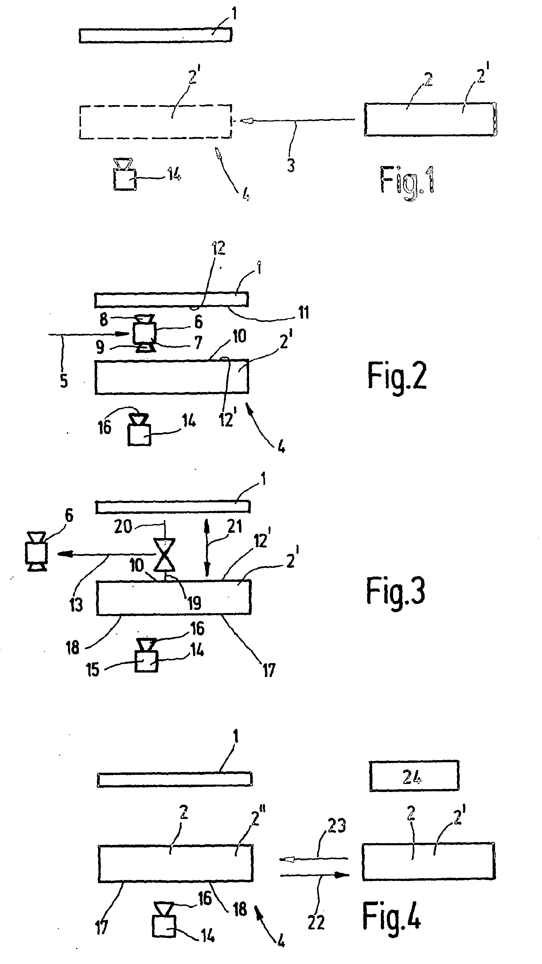

Die Zeichnungen veranschaulichen die Erfindung anhand von Ablauf-Darstellungen gemäß der Figuren 1 bis 4.

Die Figur 1 zeigt eine Druckschablone 1 einer nicht dargestellten Druckmaschine zum Aufbringen von Lotpaste auf Substrate 2 eines Druckloses. Die nicht dargestellte Druckmaschine ist als Siebdruckmaschine ausgebildet. Mittels einer Zuliefereinrichtung werden Substrate 2 des Druckloses zugeliefert, wobei beim Beginn des Druckvorgangs das erste Substrat 2' gemäß Pfeil 3 in das Drucknest 4 der Druckmaschine eingefahren wird. Diese eingefahrene Position des ersten Substrats 2' ist in Figur 1 mit gestrichelter Linie dargestellt.

Gemäß Figur 2 erfolgt nach Einfahren des ersten Substrats 2' in beabstandeter Gegenüberlage zur Druckschablone 1 ein Einfahren (Pfeil 5) einer ersten optischen Erfassungseinrichtung 6 zwischen das erste Substrat 2' und die Druckschablone 1. Die erste optische Erfassungseinrichtung 6 ist als Kamera 7 mit zwei Objektiven 8 und 9 ausgebildet, so dass gleichzeitig die Druckseite 10 des ersten Substrats 2 und die der Druckseite 10 zugeordnete Seite 11 der Druckschablone 1 inspiziert werden können. Bei dieser Inspektion werden ersten Strukturen 12 und 12' auf der Seite 11 der Druckschablone 1 und der Druckseite 10 des ersten Substrats 2' erfasst. Hierbei handelt es sich um Lageninformationen (Koordinaten) und/oder Geometrieinformationen (Form, Größe). Die Strukturen können von Öffnungen und/oder Kanten der Druckschablone 1 und/oder anderweitiger Kennzeichnungen auf der Druckschablone 1 sowie von Kanten und/oder Leiterbahnanordnungen sowie anderweitiger Kennzeichnungen auf dem ersten Substrat 2' gebildet sein. Die vorstehend erwähnte Aufzählung der Strukturen ist hier nicht abschließend wiedergegeben, es wird jedoch deutlich, dass es sich um Elemente handeln muss, die eine eindeutige Lageposition des jeweiligen Elementes mittels der optischen Erfassungseinrichtung 6 gestatten.

Ist die optische Erfassung der Strukturen von Druckschablone 1 und erstem Substrat 2' gemäß Figur 2 erfolgt, so werden diese beiden Bauelemente anhand der gewonnenen Informationen relativ zueinander positionsgenau ausgerichtet, so dass sichergestellt ist, dass beim späteren Druck die Öffnungen in der Druckschablone 1 hochpräzise in Gegenüberlage zu den entsprechenden Strukturen auf dem ersten Substrat 2' gelangen und daher beim Druck die Lotpaste hochgenau und in präziser Höhe als Lotpastendepots aufgebracht wird.

Bevor jedoch dieser Druckvorgang durchgeführt wird, erfolgt mittels einer zweiten optischen Erfassungseinrichtung 14, die als Kamera 15 mit einem Objektiv 16 ausgebildet ist, eine Erfassung von zweiten Strukturen 17 auf der der Druckseite 10 gegenüberliegenden Seite 18 des ersten Substrats 2'. Dieser Vorgang geht aus der Figur 3 hervor. Alternativ kann dieser Vorgang auch nach dem Drucken erfolgen. Da eine feste Zuordnung von ersten Strukturen 12' auf der Druckseite 10 des ersten Substrats 2' und den zweiten Strukturen 17 auf der Seite 18 des ersten Substrats 2' vorliegt und dies bei jedem Folgesubstrat ebenfalls gegeben ist, kann durch Erfassung der zweiten Strukturen 17 mittels der zweiten optischen Erfassungseinrichtung 14 die genaue Position des ersten Substrats 2' festgehalten werden, wobei auch bei nachfolgenden, gleichartigen Substraten 2 eine entsprechend genaue Ausrichtung dieser Folgesubstrate möglich ist, wenn mittels der zweiten optischen Erfassungseinrichtung 14 deren jeweilige zweiten Strukturen erfasst und mit den bei dem ersten Substrat 2' gewonnenen Referenzdaten verglichen werden. Die Folgesubstrate werden demgemäß solange ausgerichtet, bis ein entsprechender Abgleich mit den Referenzdaten erfolgt ist und genau die gewünschte, bereits beim ersten Substrat 2' vorhandene Position eingenommen wird. Da sich -in diesem Ausführungsbeispiel- die Lage, insbesondere X-Y-Lage der Druckschablone 1 nicht verändert, erfolgt stets bei allen Substraten 2 des Druckloses eine genaue Ausrichtung der Öffnungen der Druckschablone 1 gegenüber den zu bedruckenden Bereichen auf der Druckseite 10 des Substrats 2.

Bevor die Folgesubstrate gedruckt werden können, soll jedoch noch der aus der Figur 3 hervorgehende Ablauf zu Ende erläutert werden. Nachdem also die zweiten Strukturen 17 des ersten, ausgerichteten Substrats 2' erfasst wurden, fährt gemäß Pfeil 13 die erste optische Erfassungseinrichtung 6 aus dem Raum zwischen Druckschablone 1 und ersten Substrat 2' heraus. Gemäß der Pfeile 19, 20 fahren dann Druckschablone 1 und erstes Substrat 2' aufeinander zu, wobei dies vorzugsweise derart erfolgt, dass die Druckschablone 1 in Position
verbleibt und das Drucknest zusammen mit dem ersten Substrat 2' in Richtung auf die Druckschablone 1 bewegt wird. Anschließend wird der Druckvorgang durchgeführt. Danach fahren Druckschabtone 1 und erstes bedrucktes Substrat 2' gemäß Pfeil 21 auseinander, wobei dies ebenfalls vorzugsweise derart erfolgt, dass die Druckschablone 1 in ihrer Position verbleibt und sich nur das erste Substrat 2' bewegt. Anschließend wird -gemäß Pfeil 22 in Figur 4- das erste Substrat 2' aus dem Drucknest 4 herausgefahren. Es wird dann ein Folgesubstrat, also das zweite Substrat 2" in das Drucknest 4 gemäß Pfeil 23 eingefahren und mittels der zweiten optischen Erfassungseinrichtung 14 auf seiner Seite 18 inspiziert. Es werden dort die zweiten Strukturen 17 erfasst und mit den Referenzdaten des ersten Substrats 2' verglichen. Liegen Abweichungen vor, so erfolgt eine Lagekorrektur des zweiten Substrats 2" derart, dass eine korrekte Ausrichtung des zweiten Substrats 2" zur Druckschablone 1 vorliegt. Anschließend kann der Druckprozess durchgeführt werden. Dieses verkürzte Vorgehen beim zweiten Substrat 2" gegenüber dem ersten Substrat 2' kann auch bei allen Folgesubstraten 2 durchgeführt werden, das heißt, es ist ab dem zweiten Substrat 2" nicht mehr erforderlich, mit der ersten optischen Erfassungseinrichtung zwischen Substrat 2 und Druckschablone 1 einzufahren und -vor dem Druckvorgang- wieder aus diesem Bereich herauszufahren. Vielmehr kommt ab dem zweiten Substrat 2" die erste optische Erfassungseinrichtung 6 gar nicht mehr zum Einsatz, da die Ausrichtung nur noch mittels der zweiten optischen Erfassungseinrichtung 14 durchgeführt wird. Aus der Figur 4 ist eine Korrekturvorrichtung 24 erkennbar, mittels der die vorstehend erwähnten Verfahrensschritte, nämlich die Auswertung der Daten der ersten optischen Erfassungseinrichtung 6 und der zweiten optischen Erfassungsvorrichtung 14 und auch die Positionskorrekturen vorgenommen werden.

Auf diese Art und Weise ist das präzise Bedrucken einer sehr großen Stückzahl von Substraten 2 eines Druckloses mit Lotpaste innerhalb einer Zeiteinheit gewährleistet.

Aus dem Vorstehenden wird deutlich, dass durch einen Soll-IstVergleich, die Lage (Koordinaten) und/oder der Geometrie (Form, Größe) von Strukturen der Substratunterseite und/oder von Substratkanten mit Hilfe der vorher erfassten Lage (Koordinaten) und/oder der Geometrie (Form, Größe) von Strukturen und/oder Substratkanten der Substratoberseite durchgeführt und zur Ausrichtung des Substrats relativ zur Druckschablone beziehungsweise zum Drucksieb herangezogen werden kann, wobei die genaue Position der Druckschablone beziehungsweise des Drucksiebs ebenfalls durch entsprechende Erfassung von Lage (Koordinaten) und/oder der Geometrie (Form, Größe) von Strukturen und/oder Schablonenkanten erfolgt ist. Aufgrund der Erfindung entfällt die Notwendigkeit, eine Kameraeinheit zwischen Substrat und Druckschablone zur Ausrichtung ab dem zweiten Substrat jedes Druckloses vorzunehmen. Dies verringert die Gesamtzykluszeit um die zum Verfahren der Kameratraverse benötigte Zeit erheblich. Die genaue Positionsbestimmung der Strukturen kann bevorzugt mittels sogenannter Glasmaßstäbe vorgenommen werden. Ferner kann aufgrund der Erfindung mit Hilfe einer optischen Erfassungseinrichtung oder auch mehrerer optischer Erfassungseinrichtungen ein eindeutiger Bezugspunkt oder eindeutige Bezugspunkte eines Substrats (zum Beispiel Kante) ermittelt werden, so dass auch Substrate ohne besondere Kennzeichnungen, wie zum Beispiel Fiducials auf der Substratunterseite mit entsprechender Genauigkeit und Wiederholbarkeit insbesondere auch mehrfach bedruckt werden können.

Anstelle einer zweiten optischen Erfassungseinrichtung 14 im Bereich der Unterseite (Seite 18) des Substrats 2 können auch mindestens zwei zweite optische Erfassungseinrichtungen vorgesehen sein, so dass diese Einrichtungen für eine genaue Lagenerfassung des Substrats 2 nicht verfahren werden müssen. Aufgrund zweier optischer Erfassungseinrichtungen ist ein Verdreh-Fehler sofort erkennbar.

## Patentansprüche

1. Verfahren zum Ausrichten von Substrat (2) und Druckschablone (1) zueinander beim Bedrucken des Substrats (2) mit Lotpaste, mit folgenden Schritten:
a) Verbringen des ersten Substrats (2') in eine beabstandete Gegenüberlage zur Druckschablone (1),
b) Einfahren einer ersten optischen Erfassungseinrichtung (6) zwischen die Druckseite (10) des ersten Substrats (2') und die Druckschablone (1),
c) Erfassen von positionsbestimmenden ersten Strukturen (12, 12') vom ersten Substrat (2') und von der Druckschablone (1) mittels der ersten optischen Erfassungseinrichtung (6),
d) Ausrichten von erstem Substrat (2') und Druckschablone (1) zueinander anhand von bei der Strukturenerfassung gewonnenen Informationen,
e) Erfassen von Referenzdaten von positionsbestimmenden zweiten Strukturen (17) auf der der Druckseite (10) abgewandten Seite (18) des ersten, ausgerichteten Substrats (2') mittels einer zweiten optischen Erfassungseinrichtung (14),
f) Herausfahren der ersten optischen Erfassungseinrichtung (6), Entfernen des ersten Substrats (2') und Verbringen eines zweiten Substrats (2") in Gegenüberlage zur Druckschablone (1),
g) Erfassen von Ist-Daten von positionsbestimmenden zweiten Strukturen (17) auf der der Druckseite (10) abgewandten Seite des zweiten Substrats (2") mittels der zweiten optischen Erfassungseinrichtung (14),
h) Ausrichten von zweitem Substrat (2") und Druckschablone (1) zueinander anhand eines Vergleichs von Referenzdaten und Ist-Daten.

2. Verfahren zum Ausrichten von Substrat und Druckschablone zueinander beim Bedrucken des Substrats mit Lotpaste, mit folgenden Schritten:
a) Verbringen des ersten Substrats (21) in eine beabstandete Gegenüberlage zur Druckschablone (1),
b) Einfahren einer ersten optischen Erfassungseinrichtung (6) zwischen die Druckseite (10) des ersten Substrats (2') und die Druckschablone (1),
c) Erfassen von positionsbestimmenden ersten Strukturen (12, 12') vom ersten Substrat (2') und von der Druckschablone (1) mittels der ersten optischen Erfassungseinrichtung (6),
d) Gewinnung von die Relativlage von erstem Substrat (2') und Druckschablone (1) kennzeichnenden Korrekturdaten basierend auf der Strukturenerfassung,
e) Erfassen von Referenzdaten von positionsbestimmenden zweiten Strukturen (17) auf der der Druckseite (10) abgewandten Seite des ersten Substrats (2') mittels einer zweiten optischen Erfassungseinrichtung (14),
f) Herausfahren der ersten optischen Erfassungseinrichtung (6), Entfernen des ersten Substrats (2') und Verbringen eines zweiten Substrats (2") in Gegenüberlage zur Druckschabtone (1),
g) Erfassen von Ist-Daten von positionsbestimmenden zweiten Strukturen (17) auf der der Druckseite (10) abgewandten Seite des zweiten Substrats (2") mittets der zweiten optischen Erfassungseinrichtung (14),
h) Ausrichten von zweitem Substrat (2") und Druckschablone (1) zueinander anhand eines Vergleichs von Referenzdaten und Ist-Daten unter Berücksichtigung der Korrekturdaten.

3. Vorrichtung zum Ausrichten von Substrat (2) und Druckschablone (1) zueinander beim Bedrucken des Substrats (2) mit Lotpaste, insbesondere zur Durchführung des Verfahrens nach einem oder mehreren der vorhergehenden Ansprüche, mit einer zwischen Druckseite (10) des Substrats (2) und Druckschablone (1) ein- und ausfahrbaren, ersten optischen Erfassungseinrichtung (6), einer die der Druckseite (10) gegenüberliegende Seite (18) des Substrats (2) inspizierenden, zweiten optischen Erfassungseinrichtung (14) und mit einer die Erfassungsdaten der ersten optischen Erfassungseinrichtung (6) und die Inspektionsdaten der zweiten optischen Erfassungseinrichtung (14) verarbeitenden Korrekturvorrichtung (24) zur Positionskorrektur von Substrat (2) und Druckschablone (1) relativ zueinander.

4. Vorrichtung nach Anspruch 3, **dadurch gekennzeichnet, dass** das Bedrucken mittels einer Siebdruckmaschine erfolgt.

5. Vorrichtung nach einem der vorhergehenden Ansprüche 3,4 **dadurch gekennzeichnet, dass** die erste optische Erfassungseinrichtung eine Kamera (7) mit zwei einander diametral gegenüberliegenden Objektive (8,9) ist.

6. Vorrichtung nach einem der vorhergehenden Ansprüche 3-5, **dadurch gekennzeichnet, dass** die erste optische Erfassungseinrichtung (6) zwischen Druckschablone (1) und Substrat (2) einfahrbar und ausfahrbar angeordnet ist.

7. Vorrichtung nach einem der vorhergehenden Ansprüche 3-6, **dadurch gekennzeichnet, dass** die erste optische Erfassungseinrichtung (6) in X- und Y-Richtung verfahrbar ausgebildet ist.

8. Vorrichtung nach einem der vorhergehenden Ansprüche 3-7, **dadurch gekennzeichnet, dass** die zweite optische Erfassungseinrichtung (14) in X- und Y-Richtung verfahrbar ausgebildet ist.

9. Vorrichtung nach einem der vorhergehenden Ansprüche 3-8, **dadurch gekennzeichnet, dass** zwei zweite optische Erfassungseinrichtungen (14) vorgesehen sind, die verschiedene Bereiche der Seite (18) des Substrats (2) inspizierten.

## Claims

1. Process for aligning a substrate (2) and a printing stencil (1) with one another in the printing of the substrate (2) with solder paste, comprising the following steps:
a) Bringing the first substrate (2') into a position opposite to and at a distance from the printing stencil (1),
b) Introducing a first optical sensing device (6) between the printing side (10) of a first substrate (2') and the printing stencil (1),
c) Sensing the position-determining first structures (12, 12') of the first substrate (2') and of the printing stencil (1) by means of a first optical sensing device (6),
d) Aligning the first substrate (2') and the printing stencil (1) with one another on the basis of information gained from structure-sensing,
e) By means of a second optical sensing device (14), acquiring the reference data of position-determining second structures (17) on the side (18) of the first, aligned substrate (2') facing away from the printing side (10),
f) moving out the first optical sensing device (6), removing the first substrate (2') and bringing a second substrate (2") into a position opposite the printing stencil (1),
g) By means of the second optical sensing device (14), acquiring the actual data of position-determining second structures (17) on the side of the second substrate (2") facing away from the printing side (10),
h) Aligning the second substrate (2") and the printing stencil (1) with one another by comparing the reference data with the actual data.

2. Process for aligning a substrate and a printing stencil with one another in the printing of the substrate with solder paste, comprising the following steps:
a) Bringing the first substrate (2') in a position opposite to and at a distance from the printing stencil (1),
b) Introducing a first optical sensing device (6) between the printing side (10) of a first substrate (2') and the printing stencil (1),
c) Sensing the position-determining first structures (12, 12') of the first substrate (2') and of the printing stencil (1) by means of a first optical sensing device (6),
d) Obtaining the characterizing correction data for the relative position of the first substrate (2') and the printing stencil (1) based on structure sensing,
e) By means of a second optical sensing device (14), sensing the reference data of position-determining second structures (17) on the side of the first substrate (2') facing away from the printing side (10),
f) moving out the first optical sensing device (6), removing the first substrate (2') and bringing a second substrate (2") into a position opposite the printing stencil (1),
g) By means of a second optical sensing device (14), sensing the actual data of position-determining second structures (17) on the side of the second substrate (2") facing away from the printing side (10),
h) Aligning the second substrate (2") and the printing stencil (1) with one another by comparing the reference data with the actual data while taking into account the correction data.

3. Device for aligning a substrate (2) and a printing stencil (1) with one another in the printing of the substrate (2) with solder paste, particularly for the purpose of carrying out the process as defined in one or more of the preceding claims, with a first optical sensing device (6) capable of being inserted between and moved out from between the printing side (10) of the substrate (2) and printing stencil (1), with a second optical sensing device (14) inspecting the side (18) disposed opposite the printing side (10) of the substrate (2) and with a correction system (24) for processing the inspection data of the second optical sensing device (14) for the purpose of correcting the position of the substrate (2) and the printing stencil (1) relative to one another.

4. Device according to claim 3, **characterized in that** the printing is done with a screen-printing machine.

5. Device according to one of the preceding claims 3, 4, **characterized in that** the first optical sensing device is a camera (7) with two diametrically opposed objectives (8,9).

6. Device according to one of the preceding claims 3 to 5, **characterized in that** the first optical sensing device (6) is disposed insertably and removably between the printing stencil (1) and the substrate (2).

7. Device according to one of the preceding claims 3 to 6, **characterized in that** the first optical sensing device (6) is configured so as to be movable in the X- and Y-direction.

8. Device according to one of the preceding claims 3 to 7, **characterized in that** the second optical sensing device (14) is configured so as to be movable in the X- and Y-direction.

9. Device according to one of the preceding claims 3 to 8, **characterized in that** there are provided two second optical sensing devices (14) inspecting different regions of the side (18) of the substrate (2).

## Revendications

1. Procédé d'alignement de substrat (2) et de pochoir (1) l'un par rapport à l'autre lors de l'impression du substrat (2) avec de la pâte à braser, comprenant les étapes suivantes :
a) amenée du premier substrat (2') dans une position opposée au pochoir (1), distante de celui-ci,
b) insertion d'un premier dispositif de saisie optique (6) entre le côté impression (10) du premier substrat (2') et le pochoir (1),
c) saisie de premières structures (12, 12') déterminantes de position du premier substrat (2') et du pochoir (1) au moyen du premier dispositif de saisie optique (6),
d) alignement du premier substrat (2') et du pochoir (1) l'un par rapport à l'autre à l'aide d'informations obtenues lors de la saisie de structures,
e) saisie de données de référence de deuxièmes structures (17) déterminantes de position du côté (18) du premier substrat (2') aligné opposé au côté impression (10) au moyen d'un deuxième dispositif de saisie optique (14),
f) sortie du premier dispositif de saisie optique (6), enlèvement du premier substrat (2') et amenée d'un deuxième substrat (2") dans une position opposée au pochoir (1),
g) saisie de données réelles de deuxièmes structures (17) déterminantes de position du côté du deuxième substrat (2") opposé au côté impression (10) au moyen du deuxième dispositif de saisie optique (14),
h) alignement du deuxième substrat (2") et du pochoir (1) l'un par rapport à l'autre à l'aide d'une comparaison entre données de référence et données réelles.

2. Procédé d'alignement de substrat et de pochoir l'un par rapport à l'autre lors de l'impression du substrat avec de la pâte à braser, comprenant les étapes suivantes :
a) amenée du premier substrat (2') dans une position opposée au pochoir (1), distante de celui-ci,
b) insertion d'un premier dispositif de saisie optique (6) entre le côté impression (10) du premier substrat (2') et le pochoir (1),
c) saisie de premières structures (12, 12') déterminantes de position du premier substrat (2') et du pochoir (1) au moyen du premier dispositif de saisie optique (6),
d) obtention de données de correction caractérisant la position relative entre premier substrat (2') et pochoir (1) basées sur la saisie de structures,
e) saisie de données de référence de deuxièmes structures (17) déterminantes de position du côté du premier substrat (2') opposé au côté impression (10) au moyen d'un deuxième dispositif de saisie optique (14),
f) sortie du premier dispositif de saisie optique (6), enlèvement du premier substrat (2') et amenée d'un deuxième substrat (2") dans une position opposée au pochoir (1),
g) saisie de données réelles de deuxièmes structures (17) déterminantes de position du côté du deuxième substrat (2") opposé au côté impression (10) au moyen du deuxième dispositif de saisie optique (14),
h) alignement du deuxième substrat (2") et du pochoir (1) l'un par rapport à l'autre à l'aide d'une comparaison entre données de référence et données réelles en tenant compte des données de correction.

3. Dispositif d'alignement de substrat (2) et de pochoir (1) l'un par rapport à l'autre lors de l'impression du substrat (2) avec de la pâte à braser, en particulier pour la mise en oeuvre du procédé selon l'une ou plusieurs des revendications précédentes, comprenant un premier dispositif de saisie optique (6) pouvant être entré et sorti entre côté impression (10) du substrat (2) et pochoir (1), un deuxième dispositif de saisie optique (14) inspectant le côté (18) du substrat (2) opposé au côté impression (10) et un dispositif de correction (24) traitant les données de saisie du premier dispositif de saisie optique (6) et les données d'inspection du deuxième dispositif de saisie optique (14) afin de corriger la position relative du substrat (2) et du pochoir (1) l'un par rapport à l'autre.

4. Dispositif selon la revendication 3, **caractérisé en ce que** l'impression a lieu au moyen d'une machine de sérigraphie.

5. Dispositif selon l'une des revendications précédentes 3, 4, **caractérisé en ce que** le premier dispositif de saisie optique est une caméra (7) avec deux objectifs (8, 9) diamétralement opposés l'un à l'autre.

6. Dispositif selon l'une des revendications précédentes 3 à 5, **caractérisé en ce que** le premier dispositif de saisie optique (6) est disposé de manière à pouvoir être entré et sorti entre pochoir (1) et substrat (2).

7. Dispositif selon l'une des revendications précédentes 3 à 6, **caractérisé en ce que** le premier dispositif de saisie optique (6) est réalisé déplaçable dans les directions X et Y.

8. Dispositif selon l'une des revendications précédentes 3 à 7, **caractérisé en ce que** le deuxième dispositif de saisie optique (14) est réalisé déplaçable dans les directions X et Y.

9. Dispositif selon l'une des revendications précédentes 3 à 8, **caractérisé en ce qu'**il est prévu deux deuxièmes dispositifs de saisie optique (14) qui inspectent différentes zones du côté (18) du substrat (2).
